(19) Europäisches Patentamt
European Patent Office
Office européen des brevets

(11) **EP 2 901 215 B1**

(12) **FASCICULE DE BREVET EUROPEEN**

(45) Date de publication et mention
de la délivrance du brevet:
**08.07.2020 Bulletin 2020/28**

(21) Numéro de dépôt: **13770451.6**

(22) Date de dépôt: **25.09.2013**

(51) Int Cl.:
*G03F 7/20* *(2006.01)*          *G02B 27/09* *(2006.01)*

(86) Numéro de dépôt international:
**PCT/EP2013/069982**

(87) Numéro de publication internationale:
**WO 2014/048999 (03.04.2014 Gazette 2014/14)**

(54) **ILLUMINATEUR DE PHOTOLITHOGRAPHIE TELECENTRIQUE SELON DEUX DIRECTIONS**

IN ZWEI RICHTUNGEN TELEZENTRISCHER FOTOLITHOGRAFISCHER BELEUCHTER

PHOTOLITHOGRAPHIC ILLUMINATOR THAT IS TELECENTRIC IN TWO DIRECTIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.09.2012 FR 1259005**

(43) Date de publication de la demande:
**05.08.2015 Bulletin 2015/32**

(73) Titulaires:
• **Safran Electronics & Defense**
  **92100 Boulogne-Billancourt (FR)**
• **Shanghai Micro Electronics Equipment Co., Ltd.**
  **Shanghai 201203 (CN)**

(72) Inventeurs:
• **PLAINCHAMP, Bertrand**
  **F-92100 Boulogne-Billancourt (FR)**
• **MERCIER YTHIER, Renaud**
  **F-92100 Boulogne-Billancourt (FR)**

(74) Mandataire: **Regimbeau**
**20, rue de Chazelles**
**75847 Paris Cedex 17 (FR)**

(56) Documents cités:
**EP-A1- 2 354 853        EP-A2- 1 367 442**
**WO-A2-2011/039261**

EP 2 901 215 B1

## Description

### DOMAINE TECHNIQUE DE L'INVENTION

La présente invention concerne un illuminateur d'un dispositif de photolithographie, et un tel dispositif de photolithographie.

### ETAT DE L'ART

La photolithographie est une technique utilisée pour la fabrication de dispositifs semiconducteurs, en utilisant un rayonnement électromagnétique pour générer des motifs fins sur les dispositifs semiconducteurs. A cet effet, un illuminateur d'un dispositif de photolithographie illumine un masque dont l'image est projetée sur une tranche semiconductrice (également connue sous le nom anglais de « wafer »).

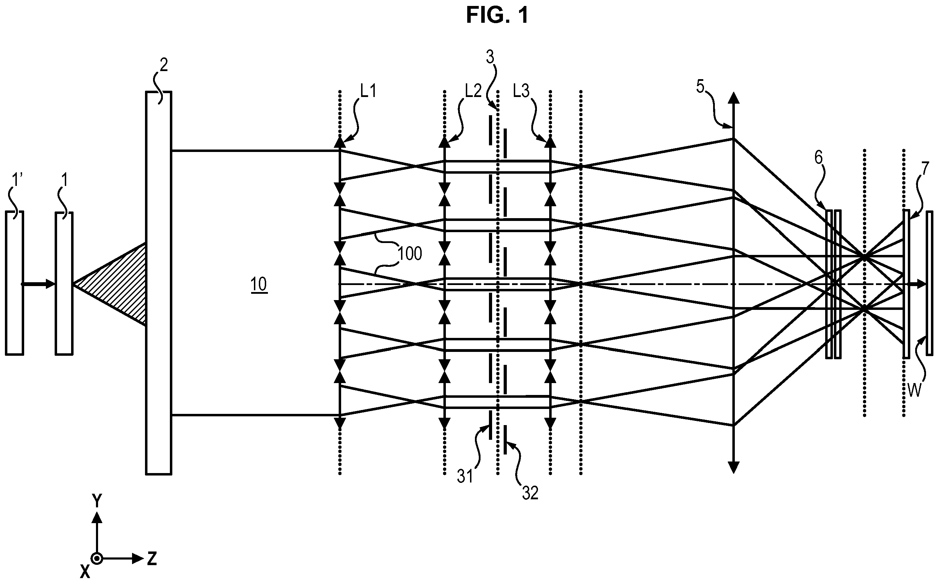

En référence à la figure 1, un illuminateur connu comporte généralement un élément optique diffractif 1 (également appelé « diffractive optical element » ou DOE en anglais) qui est illuminé par une source 1' d'illumination.

La source 1' d'illumination est par exemple une source laser.

L'élément 1 peut être n'importe quel élément généralement utilisé pour produire de la diffraction, comme par exemple une matrice en deux dimensions de microlentilles sphériques, une lentille de Fresnel, un réseau de diffraction, etc. L'élément joue le rôle d'un diffuseur optique et a pour fonction principale de produire à sa sortie une pupille de motif général voulu, par exemple en forme de disque ou d'anneau.

L'illuminateur comporte en sortie de l'élément 1 un zoom 2 formé de plusieurs lentilles. La fonction du zoom 2 est de ramener l'image de la pupille de sortie de l'élément 1 à une distance finie et de pouvoir la faire varier en dimension.

En sortie du zoom 2 est disposée une matrice L1 de micro-lentilles, constituée d'une lame plate comprenant deux faces en regard l'une de l'autre, et sur chaque face étant formé un réseau de microlentilles sphériques ou cylindriques. La matrice L1 de microlentilles décompose le faisceau incident, en sortie du zoom 2, en une multitude de sous faisceaux. En d'autres termes, la pupille de sortie de la matrice L1 est décomposée en sous-pupilles de sortie.

Une deuxième matrice L2 de microlentilles est disposée en aval de la première L1, de sorte que le système L1L2 soit afocal.

Une troisième matrice L3 de microlentilles est disposée en aval de la deuxième L2. Au foyer objet de cette troisième matrice L3 est positionné un obturateur 3, constitué d'une plaque ou d'une grille dans laquelle sont aménagées des ouvertures à intervalles réguliers. Alternativement, l'obturateur 3 peut comprendre deux plaques 31, 32, déplacées en synchronisme avec les déplacements du masque 7 et de la tranche w à éclairer selon une direction orthogonale à l'axe optique, ou deux directions orthogonales à l'axe optique et le cas échéant entre elles. On pourra se référer au document WO2007/028793 pour plus de détails sur la réalisation de cet obturateur.

Dans tous les cas, l'obturateur 3 permet de contrôler la dose, le format image, et le profil d'illumination sur le masque 7. Il est à cet égard positionné dans un plan conjugué du plan focal d'un condenseur 5, le masque 7 étant disposé légèrement en aval de celui-ci. Ceci permet d'éviter que de la lumière soit transmise en dehors du champ souhaité, générant de la lumière parasite sur la tranche en cours d'illumination. Le fait que le masque soit légèrement défocalisé par rapport au plan focal du condenseur permet d'améliorer le contrôle de la dose en lissant des variations temporelles d'énergies des impulsions lumineuses.

Le fait que le système de réseaux L1L2 en amont de l'obturateur 3 soit afocal permet de limiter la taille des sous-pupilles de sortie du système éclairant l'obturateur. Il existe ainsi une zone non éclairée, située entre les microlentilles des faisceaux, où la partie opaque de l'obturateur 3 peut se positionner sans intercepter le faisceau lorsque le champ image doit être complètement éclairé. Ceci permet une coupure franche des sous-faisceaux en sortie de l'obturateur et une obturation nette au niveau du masque.

Le foyer image de la troisième matrice L3 de microlentilles est situé au foyer objet d'un condenseur 5, afin de rendre l'illuminateur télécentrique, c'est-à-dire afin que la pupille de sortie de l'illuminateur soit à l'infini. Le condenseur 5, quant à lui, comporte une pluralité de lentilles permettant de superposer au niveau du masque les sous-faisceaux issus des matrices L1L2.

Un dispositif d'apodisation 6 est également placé entre le condenseur 5 et le masque 7.

Comme précédemment indiqué, l'obturateur 3 est positionné dans un plan conjugué du plan focal du condenseur pour assurer une obturation nette du faisceau lumineux 10.

Un tel illuminateur fournit notamment de bons résultats pour le faisceau lumineux selon une dimension, i.e. lorsque l'obturation du faisceau lumineux doit être faite selon un premier axe dans le plan de l'obturateur.

Cependant, dans l'hypothèse où l'obturation doit être faite selon deux axes du plan de l'obturateur, notamment deux axes perpendiculaires à l'axe optique et perpendiculaires entre eux, des problématiques d'imagerie se posent.

En effet, la condition de télécentricité de l'illuminateur impose que l'obturateur 3 soit positionné au foyer objet de la matrice de microlentilles L3 dans les directions des deux axes d'obturation. D'autre part, la condition de netteté de l'image de l'obturateur sur le masque impose que le foyer image de la matrice de microlentilles L3 soit positionné au foyer objet du condenseur dans les deux directions.

Ces deux conditions imposent que la matrice de microlentilles L3 ait la même distance focale selon les deux directions. Or, dans ce type d'illuminateur, la distance focale des microlentilles étant du même ordre de grandeur que l'épaisseur desdites microlentilles, il est géométriquement impossible d'assurer l'obtention de ce résultat, et donc de garantir une parfaite conjugaison entre l'obturateur et le masque dans les deux directions.

D'autre part, l'obturateur provoque un phénomène de diffraction qui rend difficile l'obtention d'une image nette de l'obturateur dans le plan du condenseur, et donc sur le masque. Plus particulièrement, la diffraction de la lumière par la grille diffuse le faisceau lumineux selon une ouverture plus grande que l'ouverture des sous-faisceaux issus des matrices de microlentilles L1L2. Il en résulte deux conséquences négatives :

- Si la diffraction est trop importante, la lumière issue de l'obturateur peut ne pas passer par la bonne microlentille de la matrice L3, créant de la diaphonie entre les sous-faisceaux 100 et des phénomènes d'interférence sur le masque.
- La diffraction par l'obturateur conduit à augmenter l'ouverture des sous-faisceaux en entrée de la troisième matrice de microlentilles L3. Or, une ouverture plus grande limite la profondeur de champ objet de la matrice de microlentilles L3, ce qui augmente la sensibilité à une défocalisation de l'obturateur par rapport au plan focal objet de cette matrice L3. Le réglage de l'illuminateur est donc rendu plus complexe.

Le document WO2011/039261 décrit un illuminateur de dispositif photolithographique comprenant, en amont d'un condenseur, un ensemble optique comprenant une pluralité de matrices de microlentilles ainsi qu'un réseau de diaphragmes d'ouvertures.

PRESENTATION DE L'INVENTION

L'invention propose de pallier au moins l'un des problèmes ci-dessus.
A cet effet, on propose selon l'invention un illuminateur de dispositif photo lithographique, comprenant :

- une source d'un faisceau lumineux,
- un condenseur,
- un système optique d'homogénéisation, comprenant deux matrices de microlentilles, disposé en amont du condenseur de sorte que le plan focal image du système optique d'homogénéisation soit positionné au plan focal objet du condenseur,
- un obturateur, disposé au plan focal objet du système optique d'homogénéisation, et

l'illuminateur étant caractérisé en ce que l'écartement des deux matrices de microlentilles, ainsi que la disposition et l'orientation des microlentilles, sont adaptés pour que le système optique d'homogénéisation présente, selon deux directions orthogonales à l'axe optique, des plans focaux image confondus et des plans focaux objet confondus.

Avantageusement, mais facultativement, l'invention est en outre complétée par au moins l'une des caractéristiques suivantes :

- les deux directions orthogonales à l'axe optique sont orthogonales entre elles.
- chaque matrice de microlentilles est une lame comprenant deux faces en regard l'une de l'autre, et la première matrice de microlentilles par rapport à la direction de propagation du faisceau lumineux comprend des microlentilles cylindriques gravées sur chacune de ses faces, les axes des cylindres des lentilles d'une face étant orthogonaux aux axes des cylindres des lentilles de l'autre face et orthogonaux à l'axe optique.
- l'écartement entre les matrices de microlentilles ainsi que la disposition et l'orientation des microlentilles sont adaptés pour que le système optique d'homogénéisation se comporte, dans une première direction orthogonale à l'axe optique, comme une lentille convergente disposée au niveau de la première face de la première matrice, le plan de l'obturateur étant au plan focal objet de ladite lentille, et le plan focal objet du condenseur étant au plan focal image de ladite lentille.
- la lentille convergente est formée par les microlentilles cylindriques sur la première face de la première matrice, les axes des cylindres s'étendant selon une deuxième direction orthogonale à l'axe optique, et orthogonale à la première direction.
- l'écartement entre les matrices de microlentilles ainsi que la disposition et l'orientation des microlentilles sont adaptés pour que le système optique d'homogénéisation se comporte, dans la deuxième direction orthogonale à l'axe optique et orthogonale à la première, comme un système comprenant :

  ◦ une lentille convergente au niveau de la deuxième face de la première matrice, et
  ◦ une lentille divergente au niveau de la première face de la seconde matrice,

de sorte que le plan de l'obturateur soit au plan focal objet de la lentille convergente, et le plan focal objet du condenseur soit au plan focal image du système.

- la lentille convergente sur la deuxième face de la première matrice d'une part et la lentille divergente d'autre part, sont formées par des microlentilles cylindriques dont les axes des cylindres s'étendent selon la première direction orthogonale à l'axe optique.
- l'illuminateur comprend en outre un réseau de diaphragmes disposé au plan focal image du système optique d'homogénéisation.
- chaque diaphragme du réseau de diaphragmes est disposé en regard d'une microlentille de la deuxième matrice de microlentilles du système optique d'homogénéisation.

L'invention a également pour objet un dispositif de photolithographie, comprenant un masque et un illuminateur selon l'invention, dans lequel l'obturateur de l'illuminateur est positionné dans un plan conjugué du plan focal image d'un condenseur.

L'invention présente de nombreux avantages.

Un illuminateur selon l'invention remplit les conditions de conjugaison entre l'obturateur et le masque à illuminer à la fois dans une première direction orthogonale à l'axe optique, mais aussi dans une seconde direction orthogonale à l'axe optique, et de préférence orthogonale à la première.

En outre, un illuminateur selon l'invention permet de contrôler l'effet de la diffraction liée à l'obturateur de manière à augmenter la netteté de l'image de l'obturateur sur le masque. Le contrôle de l'ouverture permet en outre de rendre moins sensible la troisième matrice de microlentilles L3 à une défocalisation de la grille par rapport à son plan focal objet, ce qui facilite le montage et le réglage de l'illuminateur selon l'invention.

PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

- La figure 1, déjà décrite, représente schématiquement un illuminateur connu de l'état de la technique ;
- Les figures 2a, et 2c représentent schématiquement différentes réalisations d'un illuminateur selon l'invention ;
- La figure 2b représente schématiquement un illuminateur :
- La figure 3 représente les dispositions relatives des matrices de microlentilles en aval de l'obturateur,
- La figure 4 représente l'image d'une fente de l'obturateur dans le plan focal objet du condenseur en fonction de la cohérence de faisceaux lumineux traversant un réseau de diaphragmes.

DESCRIPTION DETAILLEE D'AU MOINS UN MODE DE REALISATION DE L'INVENTION

*Description générale de l'illuminateur*

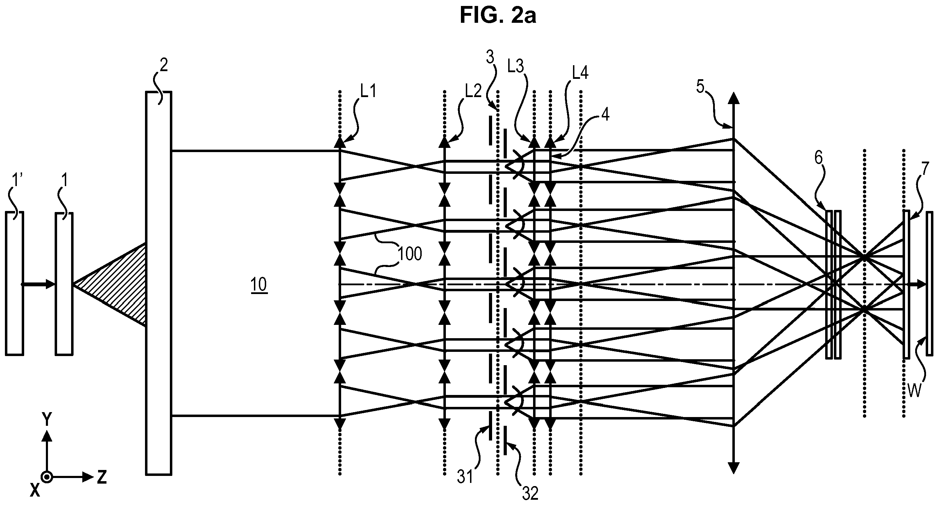

Les figures 2a à 2c montrent schématiquement une partie d'un illuminateur.

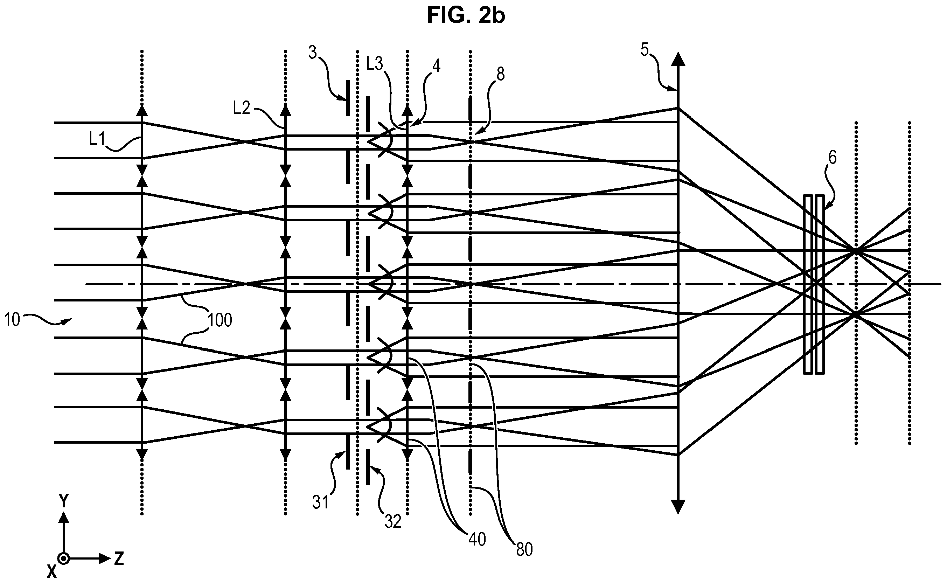

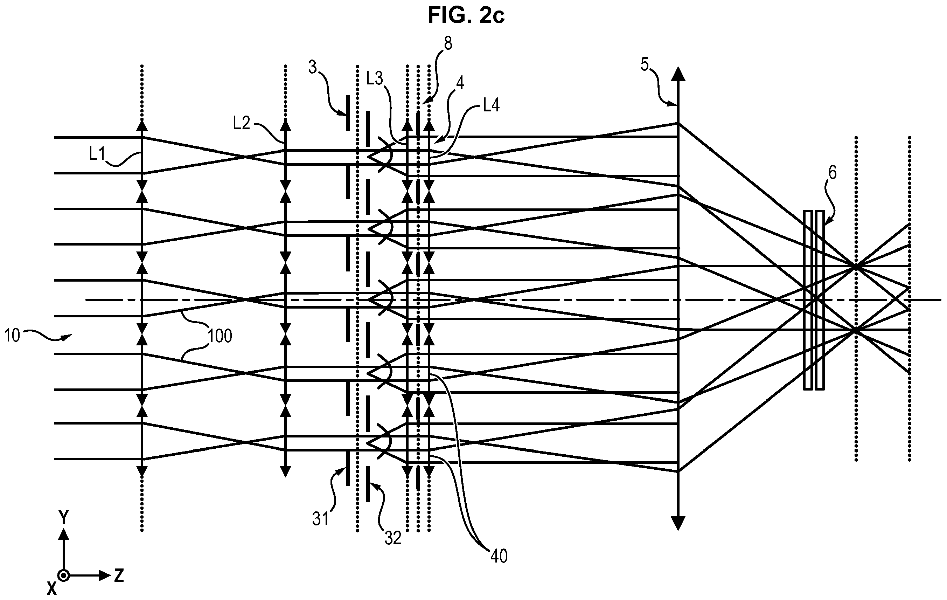

Sur la figure 2a, l'illuminateur comporte une source 1' d'un faisceau lumineux 10, par exemple une source laser, un élément diffractif 1 placé en sortie de la source 1', et un zoom 2 (ces éléments ne sont pas représentés en figures 2b et 2c).

Il comporte en outre un système afocal L1L2 constitué d'une première et d'une seconde matrice de microlentilles L1 et L2 en sortie du zoom 2.

Le faisceau 10 comprend, à sa sortie du système afocal L1L2, une pluralité de sous-faisceaux 100, constituant des sous-pupilles de sortie du système afocal L1L2.

L'illuminateur comporte un obturateur 3, représenté sous la forme de deux grilles 31, 32, et positionné au niveau des pupilles de sorties du système afocal L1L2.

Un système optique d'homogénéisation 4 comportant une troisième matrice L3 de microlentilles est placé en aval de l'obturateur 3, de sorte que celui-ci soit disposé dans le plan focal objet du système optique d'homogénéisation 4.

L'illuminateur comporte également un condenseur 5 qui permet de superposer au niveau d'un masque 7 de photolithographie les sous-faisceaux 100 issus du système afocal L1L2, un dispositif d'apodisation 6 étant prévu entre le condenseur 4 et le plan dans lequel le masque 7 est positionné.

Le plan focal objet du condenseur 5 est avantageusement disposé au plan focal image du système d'homogénéisation 4 pour assurer la netteté de l'image de l'obturateur sur le masque.

Un dispositif de photolithographie comprenant un tel illuminateur comprend également un masque 7 disposé sur une tranche w à graver, l'obturateur étant disposé dans le plan conjugué du plan focal image du condenseur 5, étant entendu qu'en utilisation, une optique de projection fait l'image du masque 7 sur la tranche w.

*Système d'homogénéisation*

Le système d'homogénéisation de l'illuminateur selon l'invention permet d'obtenir la netteté et la télécentricité de l'illuminateur dans deux directions distinctes, orthogonales à l'axe optique. Ces directions sont avantageusement orthogonales l'une à l'autre. A titre d'exemple non limitatif, on note, dans les figures 2a à 2c, Z l'axe optique, X un axe selon une première direction orthogonale à l'axe optique et orthogonale au plan de coupe des figures, et Y un axe selon une seconde direction orthogonale à l'axe optique et à l'axe X.

Le système d'homogénéisation permettant d'obtenir ce résultat comprend, outre la troisième matrice de microlentilles L3, une quatrième matrice de microlentilles L4.

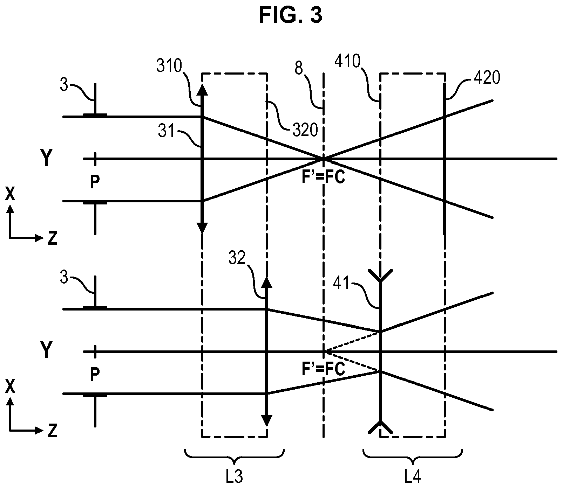

Les configurations relatives des matrices de microlentilles L3 et L4 sont représentées en figure 3. On a représenté schématiquement l'obturateur 3, situé au foyer objet P du système d'homogénéisation, et le plan focal image F' de ce système, devant être situé au plan focal objet FC du condenseur, dans les deux directions X et Y.

Les conditions de netteté et de télécentricité sont assurées si le système optique d'homogénéisation présente la même distance focale $f_1$ dans les deux directions X et Y, c'est-à-dire qu'il présente des plans focaux image confondus dans ces deux directions et des plans focaux objet également confondus dans ces deux directions.

Pour ce faire, chaque matrice de microlentilles se présente sous la forme d'une lame plane comprenant deux faces 310, 320, 410, 420 en regard l'une de l'autre, une pluralité de microlentilles cylindriques étant gravée sur au moins l'une desdites faces.

Plus précisément, la matrice de microlentilles L3 comporte des microlentilles sur chacune de ses faces 310, 320, les microlentilles étant cylindriques, les axes des microlentilles d'une face étant orthogonaux aux axes des microlentilles de l'autre face.

Les axes des microlentilles des deux faces sont orthogonaux à l'axe optique pour que les rayons lumineux parviennent aux microlentilles par leurs surfaces cylindriques.

Quant à la matrice de microlentilles L4, elle ne comporte des microlentilles cylindriques que sur sa première face 410 par rapport à la direction de propagation du flux lumineux, l'autre face 420 étant plane pour ne dévier les rayons lumineux dans aucune direction.

Les axes des cylindres des microlentilles sont orientés de sorte que, dans une première direction, par exemple la direction Y, le système d'homogénéisation se comporte comme une lentille convergente 31 disposée au niveau de la première face de la matrice L3. Le plan de l'obturateur P est alors au plan focal objet de ladite lentille 31, et le plan focal objet du condenseur FC est au plan focal image F' de ladite lentille.

Pour obtenir ce résultat, les axes des lentilles cylindriques de la première face de la matrice de microlentilles L3 s'étendent orthogonalement à la direction Y, tandis que les axes des autres lentilles cylindriques (i.e. celles de la deuxième face de la matrice L3 et de la première face de la matrice L4) s'étendent parallèlement à la direction Y, de manière à ne pas dévier la propagation des faisceaux lumineux selon la direction Y.

Ceci permet d'obtenir la netteté et la télécentricité de l'illuminateur dans la première direction Y.

Quant à la deuxième direction, en l'occurrence la direction X, les axes des cylindres des microlentilles sont orientés parallèlement à la première direction Y, pour que le système d'homogénéisation 4 se comporte comme un système comprenant :

- une lentille convergente 32 au niveau de la deuxième face de la matrice L3, et
- une lentille divergente 41 au niveau de la première face de la matrice L4, le plan de l'obturateur étant au plan focal objet de la lentille convergente 32, et le plan focal objet du condenseur étant au plan focal image F' du système.

Les lentilles sont dimensionnées de façon connue de l'homme du métier pour que leurs distances focales respectives permettent d'obtenir un tel résultat.

Ainsi, le positionnement des deux matrices de microlentilles L3 et L4, et le dimensionnement des lentilles les composant permet d'obtenir un système d'homogénéisation 4 présentant la même distance focale dans les deux directions.

*Diaphragmes*

En référence à la figure 2b, l'illuminateur comprend, afin de contrôler les phénomènes de diffraction en sortie de l'obturateur, un réseau 8 de diaphragmes d'ouverture, disposé dans le plan de la transformée de Fourier, ou plan de Fourier, du plan P de l'obturateur.

De préférence, ce réseau comprend une pluralité de diaphragmes 80, chaque diaphragme 80 étant disposé en regard d'une microlentille 40 correspondante d'une matrice adjacente du système d'homogénéisation.

Dans la figure 2b, le système d'homogénéisation 4 ne comprend qu'une matrice L3 de microlentilles ; le réseau de diaphragmes se trouve alors au plan focal image de la matrice L3 de microlentille, les diaphragmes étant en regard des microlentilles de cette matrice L3.

Dans la figure 2c, on a combiné l'utilisation d'un réseau 8 de diaphragmes avec un système d'homogénéisation 4 comprenant deux matrices de microlentilles L3 L4 comme décrit précédemment en référence à la figure 2a.

Dans ce cas, le réseau de diaphragme 8 est disposé entre les deux matrices de microlentilles L3 et L4, dans le plan de F', ce plan étant le plan de Fourier du plan de l'obturateur. Les diaphragmes se trouvent en regard des microlentilles des matrices L4 et L3 de microlentilles.

Ainsi, en cas de diffraction en sortie de l'obturateur 3, la présence de diaphragmes permet d'éviter les phénomènes de diaphonie entre les sous-faisceaux 100 du faisceau lumineux. Le réseau 8 de diaphragmes permet également d'augmenter suffisamment la profondeur de champ pour rendre la précision de l'illuminateur moins sensible à une défocalisation de l'obturateur par rapport au plan focal objet du système d'homogénéisation, et ainsi faciliter la fabrication et le réglage de l'illuminateur.

Avantageusement, le diamètre d'ouverture d'un diaphragme est de l'ordre de grandeur d'une microlentille. Par exemple, une microlentille peut présenter un diamètre de l'ordre de 0.5 mm, et un diamètre d'ouverture peut être de l'ordre de 0.1 mm.

La correction de la diffraction résultant de la présence de l'obturateur par le réseau de diaphragmes d'ouverture dépend de certains paramètres de l'illuminateur. Notamment, la netteté de l'image dépend du facteur de cohérence de l'éclairage du réseau de diaphragmes.

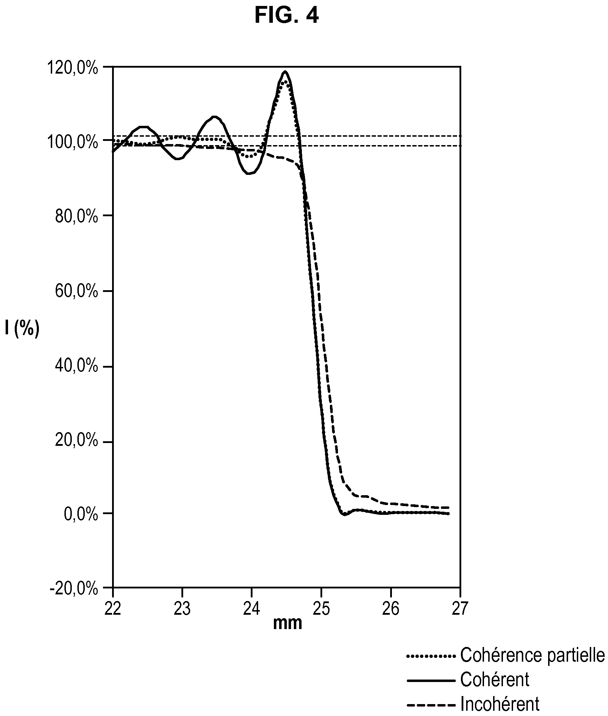

En référence à la figure 4, on montre l'image d'un bord d'une fente de l'obturateur au niveau du plan focal image du condenseur, pour différents facteurs de cohérence. Dans la figure ;

- la courbe tracée pour un faisceau « cohérent » correspond à un facteur de cohérence nul,
- la courbe tracée pour un faisceau « partiellement cohérent » correspond à un facteur de cohérence de 0.3, et
- la courbe tracée pour un faisceau « incohérent » correspond à un facteur de cohérence égal à 1.

En abscisse est donnée une position géométrique en mm par rapport à la fente. La fente est disposée à 25 mm, la partie transparente de la fente se trouvant à moins de 25 mm, et la partie opaque se trouvant après 25 mm.

En ordonnée, l'intensité lumineuse est représentée, en pourcentage de l'intensité du faisceau incident. Théoriquement, cette intensité est égale à 100% au niveau de la partie transparente de la fente et tombe à 0% au niveau de la partie opaque.

Or pour un faisceau totalement cohérent, des figures d'interférence apparaissent au niveau du côté transparent de la fente, donnant l'aspect sinusoïdal de l'intensité à ce niveau.

Ces interférences disparaissent dans le cas où le faisceau est totalement incohérent, cette amélioration se produisant toutefois au détriment de la transition entre la partie opaque et la partie transparente de la fente, à 25 mm.

Le cas où le faisceau est partiellement cohérent est un cas intermédiaire, fournissant un bon compromis entre les deux cas précédents. Plus spécifiquement, une configuration avantageuse est assurée quand le faisceau présente un facteur de cohérence compris entre 0.2 et 0.8.

Le facteur de cohérence s'écrit $\sigma = \dfrac{2f_1 \sin(\theta)}{b}$, où $f_1$ est la distance focale de la matrice de microlentilles L3 du système d'homogénéisation, $\theta$ l'angle d'éclairage de l'obturateur par rapport à l'axe optique, et b le diamètre d'ouverture des diaphragmes. Ainsi la valeur du facteur de cohérence est obtenue en ajustant les valeurs de ces trois paramètres.

On observe toutefois sur la figure 4 que des oscillations de l'intensité lumineuse subsistent au niveau de la partie transparente de la fente. Afin de moyenner ces oscillations, on prévoit avantageusement de faire varier les diamètres d'ouverture des diaphragmes, modifiant ce faisant le facteur de cohérence. De préférence, les diamètres des diaphragmes varient y compris entre deux diaphragmes adjacents.

Les variations des diamètres d'ouverture d'un diaphragme à l'autre sont comprises entre 0 et 50%, et de préférence entre 0 et 30%.

En outre, les diamètres d'ouverture des diaphragmes suivent avantageusement une répartition statistique aléatoire, et ce, quelle que soit l'illumination de l'obturateur. Cela permet de moyenner les phénomènes de diffraction, par exemple même localement pour un sous-faisceau 100 donné.

## Revendications

1. Illuminateur de dispositif photo-lithographique, comprenant :

   - une source (1') d'un faisceau lumineux,
   - un condenseur (5),
   - un système optique d'homogénéisation (4), comprenant deux matrices de microlentilles (L3, L4), disposé en amont du condenseur de sorte que le plan focal image du système optique d'homogénéisation soit positionné au plan focal objet du condenseur (5),
   - un obturateur (3), disposé au plan focal objet du système optique d'homogénéisation (4), et l'illuminateur étant **caractérisé en ce que** l'écartement des deux matrices de microlentilles, ainsi que la disposition et l'orientation des microlentilles, sont adaptés pour que le système optique d'homogénéisation (4) présente, selon deux directions (X,Y) orthogonales à l'axe optique, des plans focaux image confondus et des plans focaux objet confondus.

2. Illuminateur selon la revendication 1 dans lequel les deux directions (X,Y) orthogonales à l'axe optique sont orthogonales entre elles.

3. Illuminateur selon la revendication 1 ou 2, dans lequel chaque matrice de microlentilles (L3, L4) est une lame comprenant deux faces en regard l'une de l'autre, et la première matrice de microlentilles (L3) par rapport à la direction de propagation du faisceau lumineux comprend des microlentilles cylindriques gravées sur chacune de ses faces, les axes des cylindres des lentilles d'une face étant orthogonaux aux axes des cylindres des lentilles de l'autre face et orthogonaux à l'axe optique.

4. Illuminateur selon l'une des revendications précédentes, dans lequel l'écartement entre les matrices de microlentilles (L3, L4) ainsi que la disposition et l'orientation des microlentilles sont adaptés pour que le système optique d'homogénéisation se comporte, dans une première direction (Y) orthogonale à l'axe optique, comme une lentille convergente (31) disposée au niveau de la première face (310) de la première matrice (L3), le plan de l'obturateur étant au plan focal objet de ladite lentille, et le plan focal objet du condenseur étant au plan focal image de ladite lentille.

5. Illuminateur selon la revendication 4, dans lequel la lentille convergente (31) est formée par les microlentilles cylindriques sur la première face (310) de la première matrice (L3), les axes des cylindres s'étendant selon une deuxième direction (X) orthogonale à l'axe optique, et orthogonale à la première direction (Y).

6. Illuminateur selon l'une des revendications précédentes, dans lequel l'écartement entre les matrices de microlentilles (L3, L4) ainsi que la disposition et l'orientation des microlentilles sont adaptés pour que le système optique d'homogénéisation se comporte, dans la deuxième direction (X) orthogonale à l'axe optique et orthogonale à la première (Y), comme un système comprenant :

    - une lentille convergente (32) au niveau de la deuxième face (320) de la première matrice (L3), et
    - une lentille divergente (41) au niveau de la première face (410) de la seconde matrice (L4),

de sorte que le plan de l'obturateur (3) soit au plan focal objet de la lentille convergente, et le plan focal objet du condenseur soit au plan focal image du système.

7. Illuminateur selon la revendication 6 dans lequel la lentille convergente (32) sur la deuxième face (320) de la première matrice (L3) d'une part et la lentille divergente (41) d'autre part, sont formées par des microlentilles cylindriques dont les axes des cylindres s'étendent selon la première direction (Y) orthogonale à l'axe optique.

8. Illuminateur selon l'une des revendications précédentes, comprenant en outre un réseau de diaphragmes (8) disposé au plan focal image du système optique d'homogénéisation (4).

9. Illuminateur selon la revendication précédente, dans lequel chaque diaphragme du réseau de diaphragme (8) est disposé en regard d'une microlentille de la deuxième matrice (L4) de microlentilles du système optique d'homogénéisation (4).

10. Dispositif de photolithographie, comprenant un masque (7) et un illuminateur selon l'une des revendications précédentes, dans lequel l'obturateur (3) de l'illuminateur est positionné dans un plan conjugué du plan focal image du condenseur (5).

**Patentansprüche**

1. Beleuchter einer fotolithografischen Vorrichtung, umfassend:

    - eine Quelle (1') eines Lichtstrahls,
    - einen Kondensator (5),

    - ein optisches Homogenisierungssystem (4), zwei Mikrolinsen-Matrizen (L3, L4) umfassend, das stromaufwärts des Kondensators angeordnet ist, sodass die Bildbrennebene des optischen Homogenisierungssystems in der Objektbrennebene des Kondensators (5) positioniert ist,
    - einen Verschluss (3), der in der Objektbrennebene des optischen Homogenisierungssystems (4) angeordnet ist, und der Beleuchter **dadurch gekennzeichnet ist, dass** der Abstand der beiden Mikrolinsen-Matrizen, sowie die Anordnung und die Ausrichtung der Mikrolinsen angepasst sind, damit das optische Homogenisierungssystem (4) in zwei orthogonalen Richtungen (X, Y) zur optischen Achse zusammengenommene Bildbrennebenen und zusammengenommene Objektbrennebenen aufweist.

2. Beleuchter nach Anspruch 1, wobei die beiden orthogonalen Richtungen (X, Y) zur optischen Achse orthogonal zueinander sind.

3. Beleuchter nach Anspruch 1 oder 2, wobei jede Mikrolinsen-Matrix (L3, L4) eine Lamelle ist, die zwei einander gegenüberliegende Seiten umfasst, und die erste Mikrolinsen-Matrix (L3) in Bezug auf die Ausbreitungsrichtung des Lichtstrahls zylindrische Mikrolinsen umfasst, die in jede ihrer Seiten graviert sind, die Achsen der Zylinder der Linsen einer Seite orthogonal zu den Achsen der Zylinder der Linsen der anderen Seite und orthogonal zur optischen Achse sind.

4. Beleuchter nach einem der vorstehenden Ansprüche, wobei der Abstand zwischen den Mikrolinsen-Matrizen (L3, L4), sowie die Anordnung und die Ausrichtung der Mikrolinsen angepasst sind, damit sich das optische Homogenisierungssystem in einer ersten Richtung (Y) orthogonal zur optischen Achse als Sammellinse (31) verhält, die im Bereich der ersten Seite (310) der ersten Matrix (L3) angeordnet ist, wobei die Ebene des Verschlusses in der Objektbrennebene der Linse ist, und die Objektbrennebene des Kondensators in der Bildbrennebene der Linse ist.

5. Beleuchter nach Anspruch 4, wobei die Sammellinse (31) durch die zylindrischen Mikrolinsen auf der ersten Seite (310) der ersten Matrix (L3) gebildet wird, wobei sich die Achsen der Zylinder in einer zweiten Richtung (X) orthogonal zur optischen Achse, und orthogonal zur ersten Richtung (Y) erstrecken.

6. Beleuchter nach einem der vorstehenden Ansprüche, wobei der Abstand zwischen den Mikrolinsen-Matrizen (L3, L4), sowie die Anordnung und die Ausrichtung der Mikrolinsen angepasst sind, damit sich das optische Homogenisierungssystem in der zweiten Richtung (X) orthogonal zur optischen Achse und orthogonal zu der ersten (Y) als System verhält, das Folgendes umfasst:

- eine Sammellinse (32) im Bereich der zweiten Seite (320) der ersten Matrix (L3), und
- eine Streulinse (41) im Bereich der ersten Seite (410) der zweiten Matrix (L4),

sodass die Ebene des Verschlusses (3) in der Objektbrennebene der Sammellinse ist, und die Objektbrennebene des Kondensators in der Bildbrennebene des Systems ist.

7. Beleuchter nach Anspruch 6, wobei die Sammellinse (32) auf der zweiten Seite (320) der ersten Matrix (L3) einerseits und die Streulinse (41) andererseits durch zylindrische Mikrolinsen gebildet werden, wobei sich die Achsen der Zylinder in der ersten Richtung (Y) orthogonal zur optischen Achse erstrecken.

8. Beleuchter nach einem der vorstehenden Ansprüche, weiter ein Blendennetz (8) umfassend, das in der Bildbrennebene des optischen Homogenisierungssystems (4) angeordnet ist.

9. Beleuchter nach dem vorstehenden Anspruch, wobei jede Blende des Blendennetzes (8) gegenüber einer Mikrolinse der zweiten Matrix (L4) von Mikrolinsen des optischen Homogenisierungssystems (4) angeordnet ist.

10. Fotolithografische Vorrichtung, eine Maske (7) und einen Beleuchter nach einem der vorstehenden Ansprüche umfassend, wobei der Verschluss (3) des Beleuchters auf einer konjugierten Ebene der Bildbrennebene des Kondensators (5) positioniert ist.

**Claims**

1. Photolithographic illumination device, including:

- a light beam source (1'),
- a condenser (5),
- an optical homogenizing system (4), comprising two microlens arrays (L3, L4), disposed upstream from the condenser in such a way that the image focal plane of the optical homogenizing system is positioned in the object focal plane of the condenser (5),
- a shutter (3), disposed in the object focal plane of the optical homogenizing system (4), and

the illuminator being **characterised in that** the spacing of the two microlens arrays, as well as the arrangement and orientation of the microlenses, are adapted so that the optical homogenizing system (4) has, in two directions (X,Y) orthogonal to the optical axis, merged image focal planes and merged object focal planes.

2. Illuminator according to claim 1 wherein the two directions (X,Y) orthogonal to the optical axis are orthogonal to each other.

3. Illuminator according to claim 1 or 2, wherein each microlens array (L3, L4) is a blade comprising two sides facing each other, and the first microlens array (L3) with respect to the direction of propagation of the light beam comprises cylindrical microlenses etched on each one of the sides thereof, the axes of the cylinders of the lenses of one side being orthogonal to the axes of the cylinders of the lenses of the other side and orthogonal to the optical axis.

4. Illuminator according to one of the preceding claims, wherein the spacing between the microlens arrays (L3, L4) as well as the arrangement and orientation of the microlenses are adapted so that the optical homogenizing system behaves, in a first direction (Y) orthogonal to the optical axis, as a converging lens (31) disposed at the first side (310) of the first array (L3), with the plane of the shutter being in the object focal plane of said lens, and the object focal plane of the condenser being in the image focal plane of said lens.

5. Illuminator according to claim 4, wherein the converging lens (31) is formed by the cylindrical microlenses on the first side (310) of the first array (L3), with the axes of the cylinders extending in a second direction (X) orthogonal to the optical axis, and orthogonal to the first direction (Y).

6. Illuminator according to one of the preceding claims, wherein the spacing between the microlens arrays (L3, L4) as well as the arrangement and orientation of the microlenses are adapted so that the optical homogenizing system behaves, in the second direction (X) orthogonal to the optical axis and orthogonal to the first (Y), as a system comprising:

- a converging lens (32) at the second side (320) of the first array (L3), and
- a diverging lens (41) at the first side (410) of the second array (L4)

in such a way that the plane of the shutter (3) is in the object focal plane of the converging lens, and the object focal plane of the condenser is in the image focal plane of the system.

7. Illuminator according to claim 6 wherein the converging lens (32) on the second side (320) of the first array (L3) on the one hand and the diverging lens (41) on the other hand, are formed by cylindrical microlenses of which the axes of the cylinders extend in the first direction (Y) orthogonal to the optical axis.

8. Illuminator according to one of the preceding claims, further comprising a network of diaphragms (8) disposed in the image focal plane of the optical homogenizing system (4).

9. Illuminator according to the preceding claim, wherein each diaphragm of the diaphragm network (8) is disposed facing a microlens of the second array (L4) of microlenses of the optical homogenizing system (4).

10. Photolithographic device, comprising a mask (7) and an illuminator according to one of the preceding claims, wherein the shutter (3) of the illuminator is positioned in a conjugate plane of the image focal plane of the condenser (5).

FIG. 1

FIG. 2a

FIG. 2b

**FIG. 2c**

**FIG. 3**

EP 2 901 215 B1

## FIG. 4

**EP 2 901 215 B1**

## RÉFÉRENCES CITÉES DANS LA DESCRIPTION

### Documents brevets cités dans la description

- WO 2007028793 A

- WO 2011039261 A